# EUROPEAN PATENT APPLICATION

(11) **EP 4 709 074 A1**
(43) Date of publication of application: **11.03.2026**
(21) Application number: 24939061.8
(22) Date of filing: 12.10.2024
(51) Int. Cl.: H10B 12/00

(54) **SEMICONDUCTOR DEVICE AND PREPARATION METHOD THEREFOR, AND THREE-DIMENSIONAL DYNAMIC RANDOM ACCESS MEMORY**

(30) Priority: 07.06.2024 CN 202410740576
(71) Applicant: CXMT Corporation, Hefei, Anhui 230601 (CN)
(72) Inventor: LI, Xiaojie, Hefei, Anhui 230601 (CN)
(74) Representative: Gulde & Partner
(86) International application number: PCT/CN2024/124341
(87) International publication number: WO 2025/251488

(57) **Abstract**

Provided are a semiconductor device, a method for manufacturing the same, and a three-dimensional dynamic random access memory. The semiconductor device includes a substrate and a stack structure disposed on the substrate. The stack structure includes a support structure and memory cells stacked along a first direction. Each of the memory cells includes a cylindrical first electrode extending along a second direction; the first electrode includes a first end and a second end along the second direction, the first end is blind, and the second end has an opening and is connected to the support structure. The support structure includes a first part surrounding a part of an outer surface of the first electrode.

## Description

### CROSS-REFERENCE TO RELATED APPLICATIONS

This application is a continuation application of International Patent Application No. PCT/CN2024/124341, filed on October 12, 2024, which is based on and claims priority to Chinese Patent Application No. 202410740576.5 filed on June 07, 2024, and entitled "SEMICONDUCTOR DEVICE, METHOD FOR MANUFACTURING SAME, AND THREE-DIMENSIONAL DYNAMIC RANDOM ACCESS MEMORY", the content of which is incorporated herein in its entirety for reference.

### TECHNICAL FIELD

Embodiments of the present disclosure relate to the technical field of semiconductors, and in particular, to a semiconductor device, a method for manufacturing the same, and a three-dimensional dynamic random access memory.

### BACKGROUND

Dynamic random access memories (DRAMs) are expected to have such performance indexes as high speed, high integration density, low power consumption, etc., and with the shrinking of the structure size of semiconductor devices, the technical barrier encountered by the existing structure becomes more and more obvious. Therefore, developing more novel structures based on the prior structures is an advantageous means to break the barriers in the prior art.

The three-dimensional dynamic random access memory (3D DRAM), particularly the 3D DRAM including multilayer horizontal cells (MHCs) that typically includes a plurality of transistors stacked on a substrate, meets the above need.

### SUMMARY

According to a first aspect of the embodiments of the present disclosure, provided is a semiconductor device, which includes:
a substrate;
a stack structure disposed on the substrate, the stack structure including a support structure and memory cells stacked along a first direction;
each of the memory cells includes a cylindrical first electrode extending along a second direction, and the first electrode includes a first end and a second end along the second direction; the first end is blind, and the second end has an opening and is connected to the support structure, the support structure includes a first part surrounding a part of an outer surface of the first electrode, the first direction intersects the substrate, and the second direction is parallel to the substrate;
the stack structure further includes a first dielectric layer and a second electrode layer, where the first dielectric layer covers at least a part of an inner surface of the first electrode, at least a part of an outer surface between the first end and the second end, and at least a part of a surface of the support structure;
the second electrode layer covers the first dielectric layer.

In some embodiments, the support structure includes a second part connected to the second end, the second part having an opening, and the opening of the second part at least partially coinciding with the opening of the second end.

In some embodiments, the opening of the second part coincides with the opening of the second end.

In some embodiments, the semiconductor device includes a plurality of stack structures, the plurality of stack structures being arranged along a third direction parallel to the substrate and intersecting the second direction;
a connecting part is provided between the support structures of adjacent stack structures.

In some embodiments, the first dielectric layer covers at least a part of a surface of the connecting part.

In some embodiments, the support structure includes a third end and a fourth end in the first direction; the third end is far away from the substrate and the fourth end is close to the substrate; the connecting part includes an upper connecting part and a lower connecting part, the upper connecting part connects adjacent third ends, and the lower connecting part connects adjacent fourth ends.

In some embodiments, the upper connecting part is farther away from the substrate than the first electrode in the first direction, and the lower connecting part is closer to the substrate than the first electrode in the first direction.

In some embodiments, the first dielectric layer covering at least a part of the outer surface between the first end and the second end surrounds the first electrode with the second direction as an axis.

In some embodiments, the first dielectric layer covering at least a part of the outer surface between the first end and the second end is covered with a second electrode.

In some embodiments, the semiconductor device further includes a conductive filling layer covering the second electrode.

In some embodiments, the semiconductor device further includes a conductive filling layer, and the conductive filling layer covers the second electrode and is partially disposed between adjacent stack structures.

According to a second aspect of the embodiments of the present disclosure, provided is a three-dimensional dynamic random access memory, which includes:
any one of the foregoing semiconductor devices, a sub-word line driver, and a sense amplifier.

According to a third aspect of the embodiments of the present disclosure, provided is a method for manufacturing a semiconductor device, which includes:
providing a substrate;
forming first electrodes stacked along a first direction on the substrate, where each of the first electrodes is in a cylindrical shape extending along a second direction and includes a first end and a second end along the second direction, and the first end is blind and the second end has an opening;
forming support structures connected to the second ends at the second ends, each of the support structures including a first part surrounding a part of an outer surface of the first electrode;
forming a first dielectric layer on at least a part of an inner surface of the first electrode, at least a part of an outer surface between the first end and the second end, and at least a part of a surface of the support structure; and
forming a second electrode layer on the first dielectric layer;
the first direction intersects the substrate, and the second direction is parallel to the substrate.

In some embodiments, forming the first electrodes stacked along the first direction includes forming a plurality of first electrodes spaced apart and stacked along a third direction parallel to the substrate and intersecting the second direction;
forming the support structures includes forming a connecting part between the support structures corresponding to adjacent stacks of first electrodes, where each of the support structures includes a third end and a fourth end in the first direction, the third end is far away from the substrate, and the fourth end is close to the substrate; the connecting part includes an upper connecting part and a lower connecting part, the upper connecting part connects adjacent third ends, and the lower connecting part connects adjacent fourth ends;
forming the first dielectric layer includes forming the first dielectric layer on at least a part of a surface of the connecting part;
forming the second electrode includes forming the second electrode on a surface of the first dielectric layer on at least a part of the surface of the connecting part.

In some embodiments, the support structure is provided with a second part connected to the second end, the second part having an opening, and the opening of the second part being aligned with the opening of the second end.

In the embodiments of the present disclosure, due to the use of the technical feature of the support structure, a longer cylindrical first electrode can be manufactured under the support of the support structure, so that a capacitor with a larger capacity is obtained, the chip space occupied by the capacitor is saved, and the integration level is improved.

### BRIEF DESCRIPTION OF THE DRAWINGS

FIG. 1 is a schematic diagram of a semiconductor device shown according to an exemplary embodiment;
FIGS. 2-4 are schematic structural diagrams illustrating a step in the manufacturing of a semiconductor device shown according to an exemplary embodiment;
FIGS. 5, 10, 13, 15, 17, 19, and 21 are schematic cross-sectional views along Aa of a part of a structure in a step in the manufacturing of a semiconductor device shown according to an exemplary embodiment;
FIGS. 6, 8, 11, 14, 16, 18, 20, and 22 are schematic cross-sectional views along Bb of a part of a structure in a step in the manufacturing of a semiconductor device shown according to an exemplary embodiment;
FIGS. 7, 9, 12, 23, and 24 are schematic cross-sectional views along Cc of a part of a structure in a step in the manufacturing of a semiconductor device shown according to an exemplary embodiment.

### DETAILED DESCRIPTION

The technical solutions of the present disclosure will be further elaborated below with reference to the drawings and embodiments. While exemplary implementations of the present disclosure are shown in the drawings, it should be understood that the present disclosure may be implemented in various forms and should not be limited by the embodiments set forth herein. Rather, these embodiments are provided so that the present disclosure will be more thoroughly understood and the scope of the present disclosure will be fully conveyed to those skilled in the art.

The present disclosure is more specifically described in the following paragraphs with reference to the drawings by way of example. Advantages and features of the present disclosure will become apparent from the following description and claims. It should be noted that the drawings are all in a very simplified form and not to precise scale, and are provided only for the purpose of facilitating a convenient and clear description of the embodiments of the present disclosure.

It will be understood that the meaning of "on", "above", and "over" in the present disclosure should be interpreted in the broadest manner such that "on" not only includes the meaning of "on" something with no intermediate feature or layer therebetween (i.e., directly on something) but also includes the meaning of "on" something with an intermediate feature or a layer therebetween.

In the embodiments of the present disclosure, the terms "first", "second", "third", and the like are used for distinguishing similar objects and are not necessarily used for describing a particular order or sequence.

In the embodiments of the present disclosure, the term "layer" refers to a material portion that includes a region having a thickness. A layer may extend over the entirety of the underlying or overlying structure or may have an extent that is less than the extent of the underlying or overlying structure. Furthermore, a layer may be a region of a homogeneous or inhomogeneous continuous structure having a thickness less than the thickness of a continuous structure. For example, a layer may be located between a top surface and a bottom surface of a continuous structure, or a layer may be located between any pair of horizontal planes at the top surface and the bottom surface of the continuous structure. A layer may extend horizontally, vertically, and/or along inclined surfaces. A layer may include a plurality of sub-layers.

It should be noted that unless conflicting, the technical solutions described in the embodiments of the present disclosure may be arbitrarily combined.

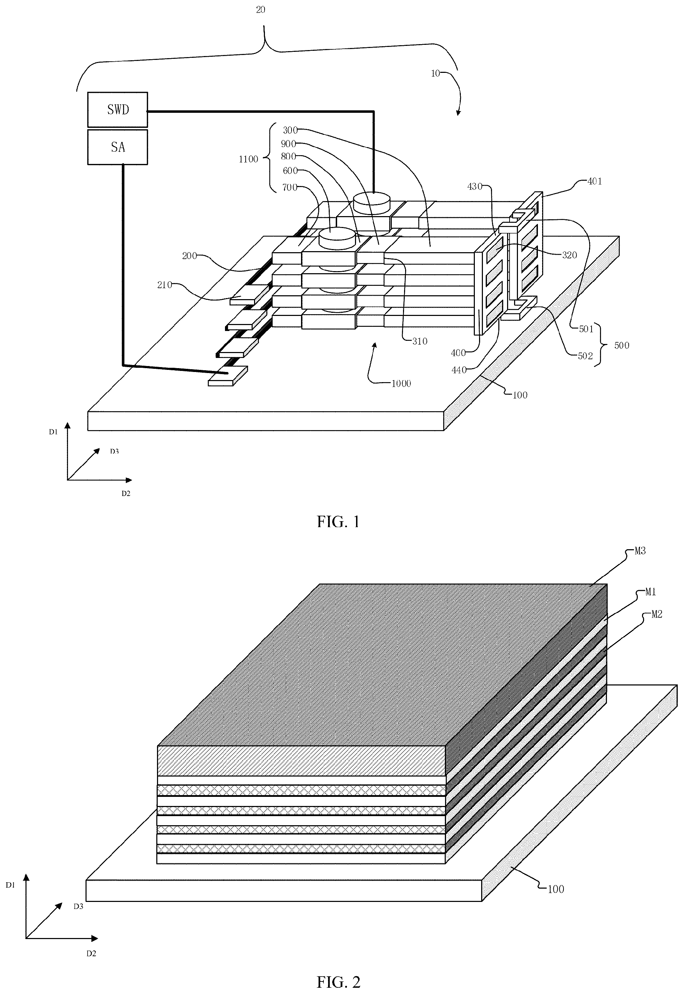

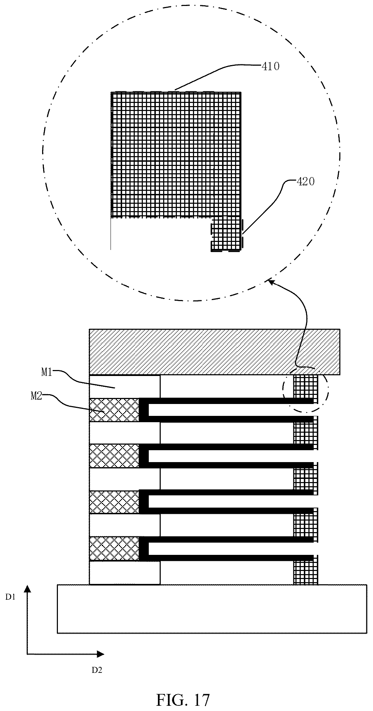

According to a first aspect of the embodiments of the present disclosure, as shown in FIG. 1 and FIG. 17, provided is a semiconductor device 10, which includes:
a substrate 100; and
a stack structure 1000 disposed on the substrate, the stack structure including a support structure 400, 401 and memory cells 1100 stacked along the first direction;
each memory cell includes a cylindrical first electrode 300 extending along the second direction, and the first electrode includes a first end 310 and a second end 320 along the second direction, where the first end is blind and the second end has an opening and is connected to the support structure, the support structure includes a first part 410 surrounding a part of the outer surface of the first electrode, the first direction D1 intersects the substrate, and the second direction D2 is parallel to the substrate;
the stack structure further includes: a first dielectric layer C3 and a second electrode layer C4, where the first dielectric layer covers at least a part of the inner surface of the first electrode, at least a part of the outer surface between the first end and the second end, and at least a part of the surface of the support structure;
the second electrode layer covers the first dielectric layer.

In some embodiments, the support structure includes: a second part 420 connected to the second end. The second part has an opening, and the opening of the second part at least partially coincides with the opening of the second end, and preferably, the opening of the second part coincides with the opening of the second end.

In some embodiments, the semiconductor device includes a plurality of stack structures. The plurality of stack structures are arranged along the third direction D3, and the third direction is parallel to the substrate and intersects the second direction;
a connecting part 500 is provided between the support structures 400, 401 of adjacent stack structures.

In some embodiments, the first dielectric layer covers at least a part of the surface of the connecting part.

In some embodiments, the support structure includes a third end 430 and a fourth end 440 in the first direction; the third end is far away from the substrate and the fourth end is close to the substrate. The connecting part includes an upper connecting part 501 and a lower connecting part 502; the upper connecting part connects adjacent third ends and the lower connecting part connects adjacent fourth ends.

In some embodiments, the upper connecting part is farther away from the substrate than the first electrode in the first direction, and the lower connecting part is closer to the substrate than the first electrode in the first direction.

In some embodiments, the first dielectric layer covering at least a part of the outer surface between the first end and the second end surrounds the first electrode with the second direction as the axis.

In some embodiments, the first dielectric layer covering at least a part of the outer surface between the first end and the second end is covered with a second electrode.

In some embodiments, the semiconductor device further includes a conductive filling layer C5, and the conductive filling layer covers the second electrode.

In some embodiments, the semiconductor device further includes a conductive filling layer, and the conductive filling layer covers the second electrode and is partially disposed between adjacent stack structures.

In some embodiments, the memory cell further includes an access transistor including a source 700, a drain 900, a gate 600, and an active layer 800 connected to the source and the drain; the drain is connected to the first end of the first electrode. The gates of the corresponding access transistors in the memory cells of different layers of the stack structure are connected to form a word line extending along the first direction.

In some embodiments, the semiconductor device further includes bit lines 200 and lead-out structures 210. The bit lines extend along the third direction. There are a plurality of bit lines, which are stacked along the first direction, are arranged corresponding to the memory cells in the stack structure, and are connected to the sources of the access transistors.

In some embodiments, the semiconductor device includes a plurality of stack structures, and the plurality of stack structures are arranged along the third direction. The sources of the access transistors of the memory cells of corresponding layers of different stack structures are connected to the same bit line.

According to a second aspect of the embodiments of the present disclosure, as shown in FIG. 1, provided is a three-dimensional dynamic random access memory 20, which includes: any one of the foregoing semiconductor devices, a sub-word line driver SWD, and a sense amplifier SA. The sub-word line driver is connected to the word lines, and the sense amplifier is connected to the bit lines through the lead-out structure.

In some embodiments, one of the sub-word line driver and the sense amplifier is disposed on the substrate of the semiconductor device and is connected to the semiconductor device through wiring.

In some embodiments, the sub-word line driver and the sense amplifier are disposed on the substrate of the semiconductor device at the same time and are connected to the semiconductor device through wiring.

In some embodiments, the three-dimensional dynamic random access memory further includes another substrate; one of the sub-word line driver and the sense amplifier is disposed on the another substrate, and the another substrate is bonded to the semiconductor device. One of the sub-word line driver and the sense amplifier is connected to the semiconductor device through bonding and wiring.

In some embodiments, the three-dimensional dynamic random access memory further includes another substrate; the sub-word line driver and the sense amplifier are disposed on the another substrate at the same time, and the another substrate is bonded to the semiconductor device. The sub-word line driver and the sense amplifier are connected to the semiconductor device through bonding and wiring.

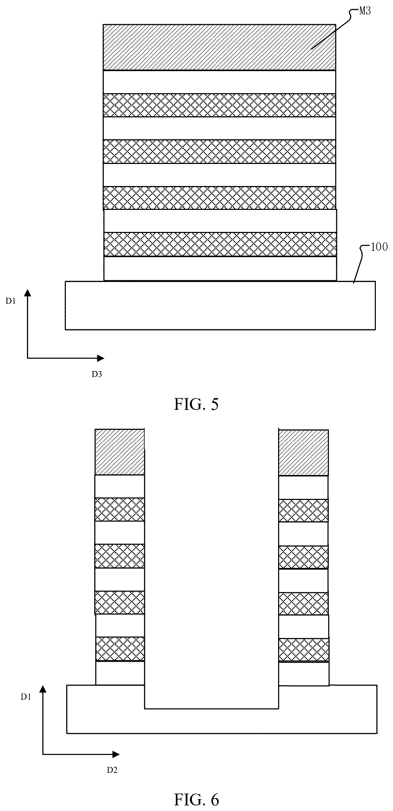

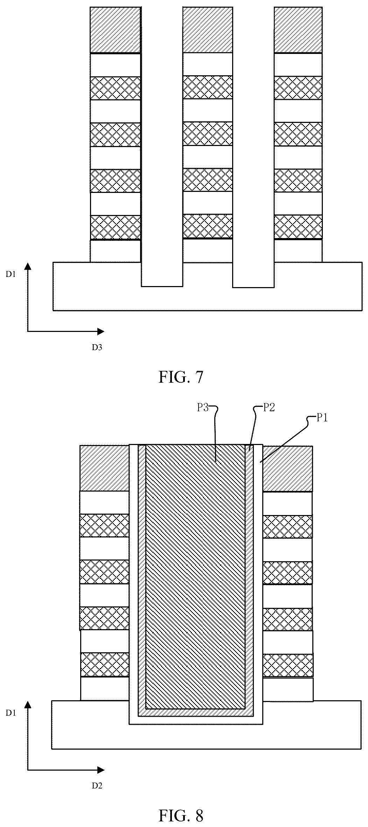

According to a third aspect of the embodiments of the present disclosure, as shown in FIGS. 2-24, provided is a method for manufacturing a semiconductor device, which includes:
providing a substrate, where optionally, the substrate may be made of monocrystalline silicon, silicon germanium, silicon carbide, and other semiconductor materials, and may include other previously prepared structures, such as transistors disposed in the substrate; and
forming first electrodes stacked along the first direction on the substrate, where each first electrode is in a cylindrical shape extending along the second direction and includes a first end and a second end along the second direction, and the first end is blind and the second end has an opening.

Specifically, an initial stack structure is formed on the substrate, and the initial stack structure is formed by alternately preparing a material layer M1 and a material layer M2.

In some embodiments, the initial stack structure may be formed by alternately depositing silicon nitride and silicon oxide, or may be formed by alternately preparing monocrystalline silicon and monocrystalline silicon germanium manufactured by epitaxial growth, or silicon oxide and monocrystalline silicon, or silicon oxide and polycrystalline silicon, or two different thin-film materials having a high etching selectivity. The material layer M1 and material layer M2 represent two different materials that are chosen.

In some embodiments, a barrier layer M3 is formed on the initial stack structure. The barrier layer M3 can be used as an etching stop layer, or a stop layer in the chemical mechanical planarization process, or protects the initial stack structure from collapse during an etching process. Optionally, the material of the barrier layer M3 is titanium nitride.

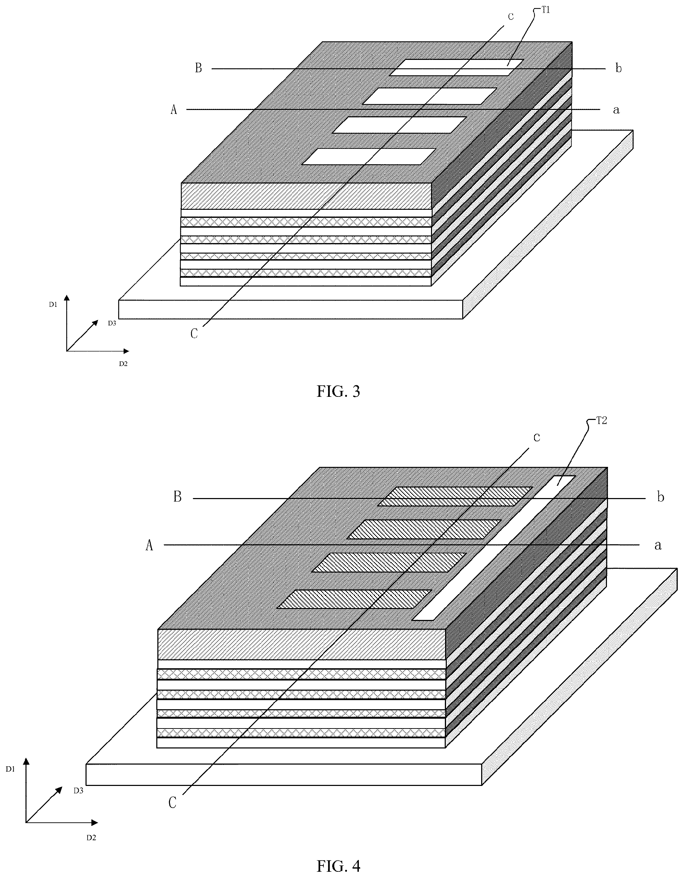

As shown in FIG. 3 and FIGS. 5-7, trenches T1 are formed in the initial stack structure through a patterning process. The trenches have a first preset width and the trench spacing is a second preset width, and optionally, the first preset width is related to the spacing between the stack structures to be manufactured, and the second preset width is related to the width of the first electrode to be manufactured.

In some embodiments, the patterning process includes forming a photoresist on the barrier layer M3, exposing the photoresist to light to form a pattern of spaced trenches, and etching the barrier layer and the initial stack structure through the patterned photoresist to form the trenches.

In some embodiments, the patterning process further includes forming a hard mask on the barrier layer M3, forming a photoresist on the hard mask and exposing the photoresist to light to form a pattern of spaced trenches, etching the hard mask through the patterned photoresist to transfer the pattern of the trenches to the hard mask, stripping the photoresist, and etching the barrier layer and the initial stack structure through the patterned hard mask.

In some embodiments, as the process for manufacturing semiconductors evolves, the integration level increases and the size shrinks. The first preset width and the second preset width which are required cannot be formed by performing the patterning process one time, and it is required to perform the patterning process multiple times to form the first preset width and the second preset width. For example, a litho-etch-litho-etch process (LELE), or a self-aligned double patterning process (SADP), or a self-aligned quadruple patterning process (SAQP) is performed.

In some embodiments, the method for etching the trench may be the dry etching process.

In some embodiments, to ensure that the etching is complete, the depth of the trench will generally be greater than the initial stack structure.

As shown in FIG. 4 and FIGS. 8-9, the trenches T1 are first filled with a protective layer, preferably sequentially filled with a protective layer P1, a protective layer P2, and a protective layer P3, and then the trench T2 is formed.

In some embodiments, the protective layer is manufactured by a physical vapor deposition (PVD) process, an atomic layer deposition (ALD) process, a pulsed laser deposition (PLD) process, a chemical vapor deposition (CVD) process, vacuum evaporation, furnace deposition, and the like.

In some embodiments, the protective layer is selected from silicon oxide, silicon nitride, silicon oxynitride, silicon carbonitride, or metal oxides such as tantalum oxide, hafnium oxide, aluminum oxide, polycrystalline silicon, combinations thereof, and the like.

In some embodiments, preferably, the protective layer P1 is silicon oxide, the protective layer P2 is silicon nitride, and the protective layer P3 is polycrystalline silicon.

The process for forming the trench T2 may be similar to that for forming the trenches T1 and will not be described again.

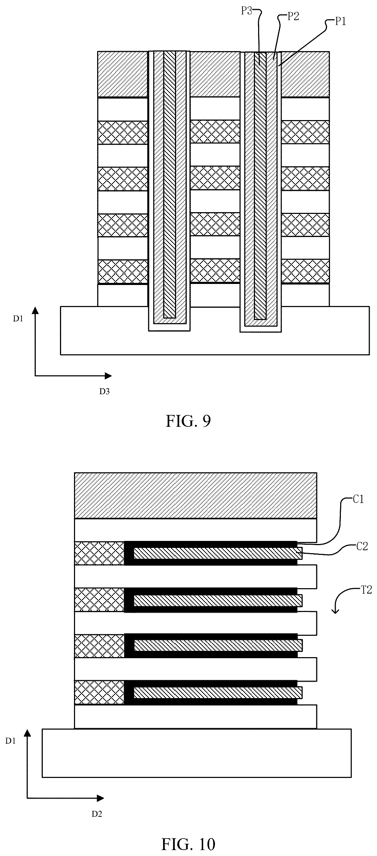

Further, as shown in FIGS. 10-12, the material layers M2 are etched through the trench T2, and then the electrode layer C1 and the filling layer C2 are deposited.

Specifically, etching the material layer M2 through the trench T2 may be laterally etching the material layer M2 using the isotropic etching method; preferably, the isotropic etching method includes wet etching, and optionally, in the wet etching process, the etching rate of the etching solution for the material layer M2 is greater than the etching rate of the etching solution for the material layer M1.

Further, in the space left after removing the material layer M2, an electrode layer C1 is deposited, and the electrode layer C1 forms a first electrode after the subsequent processes are completed.

In some embodiments, the electrode layer C1 may include metals, metal nitride, metal oxide, metal silicide, conductive carbon, and combinations thereof, such as titanium (Ti), titanium nitride (TiN), titanium aluminum nitride (TiAlN), titanium carbonitride (TiCN), tantalum (Ta), tantalum nitride (TaN), tantalum aluminum nitride (TaAlN), tantalum carbonitride (TaCN), ruthenium (Ru), platinum (Pt), or combinations thereof, or non-metallic materials such as polycrystalline silicon, gallium indium tin oxide, indium tin oxide, or combinations thereof. Preferably, the electrode layer C1 is titanium nitride.

In some embodiments, the electrode layer C1 may be manufactured by a process selected from a physical vapor deposition (PVD) process, an atomic layer deposition (ALD) process, a pulsed laser deposition (PLD) process, a chemical vapor deposition (CVD) process, vacuum evaporation, furnace deposition, and the like.

Further, after the electrode layer C1 is formed, a filling layer C2 is deposited.

In some embodiments, the filling layer C2 may include metals, metal nitride, metal oxide, metal silicide, conductive carbon, and combinations thereof, such as titanium (Ti), titanium nitride (TiN), titanium aluminum nitride (TiAlN), titanium carbonitride (TiCN), tantalum (Ta), tantalum nitride (TaN), tantalum aluminum nitride (TaAlN), tantalum carbonitride (TaCN), ruthenium (Ru), platinum (Pt), or combinations thereof, or non-metallic materials such as polycrystalline silicon, gallium indium tin oxide, indium tin oxide, or combinations thereof. Preferably, the filling layer C2 is polycrystalline silicon.

In some embodiments, the filling layer C2 may be manufactured by a process selected from a physical vapor deposition (PVD) process, an atomic layer deposition (ALD) process, a pulsed laser deposition (PLD) process, a chemical vapor deposition (CVD) process, vacuum evaporation, furnace deposition, and the like.

Further, a part of the filling layer C2, and a part of the electrode layer C1 are removed by an etching process.

In some embodiments, part of the electrode layer C1 and part of the filling layer C2 are formed in the initial stack structure that has been etched and therefore are shielded by the barrier layer M3. For the etching process, the isotropic etching process can be used to directly remove other parts of the filling layer C2 and the electrode layer C1.

In some embodiments, the anisotropic etching process includes a dry etching process, a plasma etching process, and the like.

In some embodiments, the filling layer C2 is made of polycrystalline silicon and the electrode layer C1 is made of titanium nitride, and different dry etching processes are required for etching, so the filling layer C2 is etched first, and then the electrode layer C1 is etched.

In some embodiments, to ensure that the filling layer C2 and the electrode layer C1 are etched away, part of the material will be etched excessively, and the remaining fill layer may be farther away from the trench T2 than the barrier layer M3. As shown in FIG. 10, the remaining electrode layer C1 is farther away from the trench T2 than the filling layer C2.

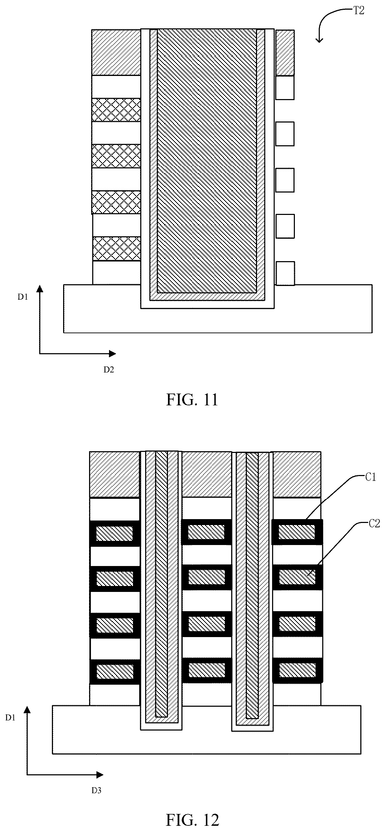

In some embodiments, as shown in FIG. 12, the electrode layer C1 forms a cylindrical structure in the space left after the material layer M2 is removed, and an opening is formed at the end close to the trench T2, and the end far away from the trench T2 is blind.

A support structure connected to the second end is formed at the second end, and the support structure includes a first part surrounding a part of the outer surface of the first electrode;

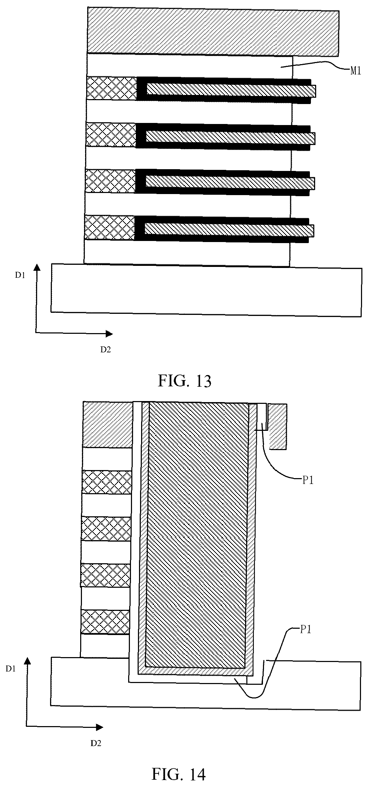

As shown in FIGS. 13-18, a recess with a preset depth is etched in the material layer M1 through the trench T2. The preset depth is related to the size of the support structure formed in the subsequent process; if a large support structure is required to be manufactured, a deep preset depth is set, and if a narrow support structure is required, a shallow preset depth is set. It can be understood that the support structure occupies the outer surface of the first electrode in the subsequent manufacturing process, and the deeper the preset depth, the larger the occupied outer surface of the first electrode, and accordingly the smaller the influence on the capacity of the corresponding storage capacitor.

Specifically, etching the material layer M1 through the trench T2 may be laterally etching the material layer M1 using the isotropic etching method; preferably, the isotropic etching method includes wet etching, and optionally, in the wet etching process, the etching rate of the etching solution for the material layer M1 is greater than the etching rate of the etching solution for the electrode layer C1 and the filling layer C2.

In some embodiments, the material layer M1 and the protective layer P1 are made of the same material or similar materials, and the etching solution has the same or similar etching rate for the material layer M1 and the protective layer P1, so that a part of the protective layer P1 is removed when the material layer M1 is etched. As shown in FIG. 14, compared with FIG. 11, at the Bb cross section, after the material layer M1 is etched, the protective layer P1 is further etched, and shallow trenches are formed at the positions shielded by the barrier layer M3 and the substrate. The shallow trench at the barrier layer M3 is formed in the barrier layer M3 and thus the relative position of the shallow trench is higher than the recess with the preset depth near the barrier layer M3 in FIG. 13, and the shallow trench at the substrate is formed in the substrate and thus the relative position of the shallow trench is lower than the recess with the preset depth near the substrate in FIG. 13.

Further, a support layer S1 is formed in the recesses with the preset depth. Optionally, the support layer S1 material is formed in the recesses with the preset depth and in the trench T2 and on the surface of the barrier layer M3 by a deposition process, then the excess support layer S1 material is removed by etching, and the support layer S1 is formed in the recesses with the preset depth by controlling the etching process, and the remaining support layer S1 exposes at least the end faces of the filling layer C2.

Optionally, the deposition process for forming the support layer S1 may be selected from a physical vapor deposition (PVD) process, an atomic layer deposition (ALD) process, a pulsed laser deposition (PLD) process, a chemical vapor deposition (CVD) process, vacuum evaporation, furnace deposition, and the like.

Optionally, the material of the support layer S1 is selected from silicon nitride, silicon oxide, silicon oxynitride, silicon carbonitride, silicon oxycarbonitride, silicon oxycarbide, silicon carbide, and the like. Preferably, the support layer S1 is selected from silicon carbonitride.

Optionally, the etching process for removing the excess support layer S1 material may be selected from an anisotropic etching process or an isotropic etching process. Preferably, the isotropic etching process is used. Specifically, the isotropic etching method includes wet etching, and optionally, in the wet etching process, the etching rate of the etching solution for the support layer S1 is greater than the etching rate of the etching solution for the barrier layer M3, the electrode layer C1, and the filling layer C2.

In some embodiments, the remaining support layer S1 exposes the end faces of the filling layer C2 and the end faces of the electrode layer C1 located at the edge opposite to the trench T2.

In some embodiments, the electrode layer C1 is farther away from the trench T2 than the filling layer C2, and the support layer S1 shields the edge of the electrode layer C1 opposite to the trench T2, that is, a second end of the subsequently formed first electrode.

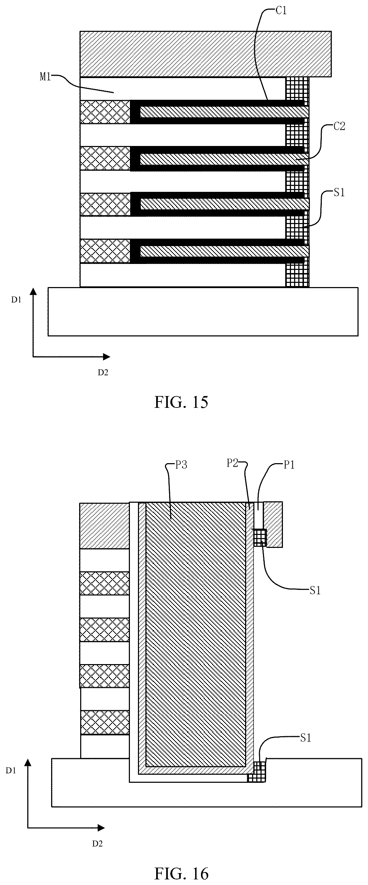

In some embodiments, as shown in FIG. 16, at the Bb cross section, after the material layer M1 is etched, the protective layer P1 is further etched, and shallow trenches are formed at the positions shielded by the barrier layer M3 and the substrate, the support layer S1 material is deposited in the shallow trenches when the support layer S1 material is formed, and the support layer S1 is formed in the shallow trenches after the excess support layer S1 material is removed by etching. Since the shallow trench at the barrier layer M3 is formed in the barrier layer M3, the relative position of the support layer S1 in the shallow trench at the barrier layer M3 is higher than the uppermost end of the support layer S1 in FIG. 15, that is, the third end of the support structure formed in the subsequent process. Since the shallow trench at the substrate is formed in the substrate, the support layer S1 in the shallow trench at the substrate is lower than the lowermost end of the support layer S1 in FIG. 15, that is, the fourth end of the support structure formed in the subsequent process.

Further, as shown in FIGS. 17-18, the filling layer C2, a part of the material layer M1, the protective layer P1, the protective layer P2, and the protective layer P3 are removed, and the inner surface and a part of the outer surface of the electrode layer C1 are exposed. Optionally, an isotropic etching process, preferably the wet etching, is used to remove material of the layers. It can be understood that the filling layer C2, a part of the material layer M1, the protective layer P1, the protective layer P2, and the protective layer P3 may be removed in one etching process, or may be removed step by step using different etching processes. Optionally, the etching rate of the etching solution of the wet etching process for the support layer S1, the barrier layer M3, and the electrode layer C1 is less than the etching rate of the etching solution for the filling layer C2, a part of the material layer M1, the protective layer P1, the protective layer P2, and the protective layer P3.

In some embodiments, as shown in FIG. 17, it can be seen in a partial enlarged view that the remaining support layer S1, i.e., the support structure in the semiconductor device, has a first part 410 surrounding a part of the outer surface of the electrode layer C1 (i.e., the first electrode in the semiconductor device) and a second part 420 connected to the second end of the first electrode.

In some embodiments, in the previous step, as shown in FIG. 15, the etching of the support layer S1 material is sufficient to completely expose the end faces of the filling layer C2, and the second part of the support structure formed in this step is self-aligned with the second end of the first electrode. The space remaining after the removal of the filling layer C2 in the second end of the first electrode forms an opening of the second end and the space remaining after the removal of the filling layer C2 in the second part of the support structure forms an opening of the second part. The opening of the second end coincides with the opening of the second part.

In some embodiments, in the previous steps, as shown in FIG. 15, if the supporting layer S1 material is not etched sufficiently, only parts of the end faces of the filling layer C2 are exposed, and the remaining support layer S1 may shield a part of the filling layer C2. Thus, in this step, the space remaining after the removal of the filling layer C2 in the second end of the first electrode forms an opening of the second end and the space remaining after the removal of the filling layer C2 in the second part of the support structure forms an opening of the second part. The resulting opening of the second part of the support structure only partially coincides with the opening of the second end of the first electrode.

In some embodiments, in the previous step, as shown in FIG. 15, the etching of the support layer S1 material is sufficient, and the remaining support layer S1 completely exposes the end faces of the filling layer C2 and the end faces of the electrode layer C1 located at the edge opposite to the trench T2, and thus, in this step, a first part surrounding a part of the outer surface of the electrode layer C1 (i.e., the first electrode in the semiconductor device) is formed, and the formed support structure does not include a second part connected to the second end of the first electrode.

In some embodiments, in the previous step, the bottom surface of the recess with the preset depth in the second direction is flush with the end face of the electrode layer C1 located at the edge opposite to the trench T2, and thus, in this step, the formed support structure has the second part connected to the second end of the first electrode, without forming the first part surrounding a part of the outer surface of the electrode layer C1 (i.e., the first electrode in the semiconductor device).

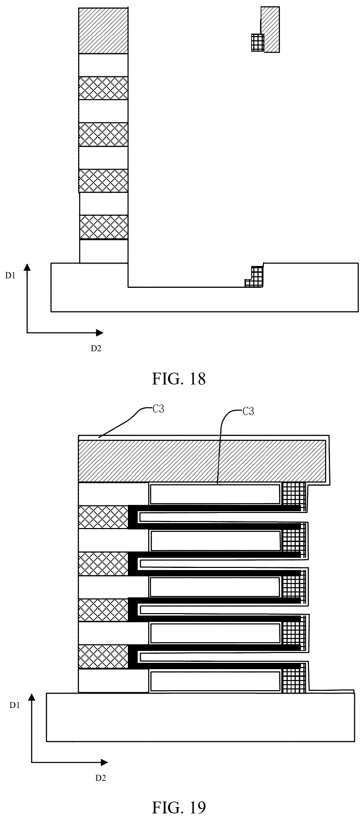

In some embodiments, as shown in FIG. 18, the support layer S1 formed in the shallow trenches will be left to form connecting parts in the semiconductor device. The support layer S1 in the shallow trench at the barrier layer M3 forms an upper connecting part, and the support layer S1 in the shallow trench at the substrate forms a lower connecting part. It can be understood that since the relative position of the support layer S1 remaining in the shallow trench at the barrier layer M3 is higher than the uppermost end of the support layer S1 remaining in FIG. 17, the resulting upper connecting part is higher than the third end of the support structure; similarly, since the relative position of the support layer S1 remaining in the shallow trench at the substrate is lower than the lowermost end of the support layer S1 remaining in FIG. 17, the resulting lower connecting part is lower than the fourth end of the support structure.

In some embodiments, as shown in FIG. 18, between the upper connecting part and the lower connecting part, if the etching is insufficient or a part of the support layer S1 is intentionally left in the foregoing process steps, connecting parts connecting adjacent support structures are formed.

Further, as shown in FIGS. 19-23, a first dielectric layer C3 is formed on at least a part of the inner surface of the first electrode, at least a part of the outer surface between the first end and the second end, and at least a part of the surface of the support structure, and a second electrode layer C4 is formed on the first dielectric layer. In the foregoing steps, the filling layer C2, a part of the material layer M1, the protective layer P1, the protective layer P2, and the protective layer P3 are removed, and the inner surface and a part of the outer surface of the electrode layer C1 are exposed. Thus, in this step, the first dielectric layer C3 may be formed on the exposed surface of the electrode layer C1 by a single deposition process. The first dielectric layer C3 is formed on the inner surface of the first electrode, the exposed surface of the support structure connected to the first electrode, the exposed outer surface between the first and second ends of the first electrode, the upper surface of the barrier layer M3, and the inner surface of the trench T2.

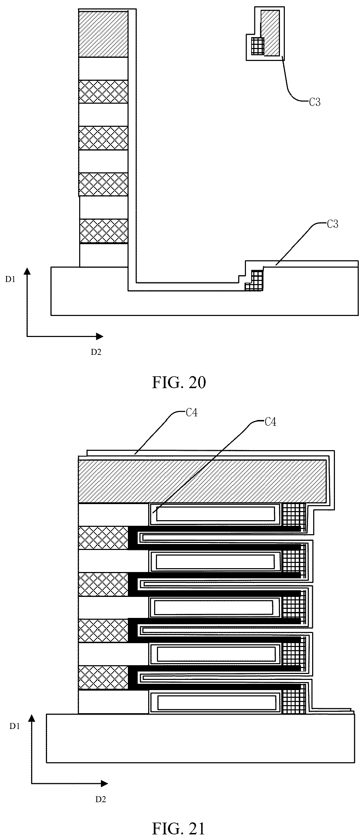

In some embodiments, as shown in FIG. 20, the first dielectric layer C3 is formed on the exposed surfaces of the upper connecting part and the barrier layer connected to the upper connecting part, and the first dielectric layer C3 is formed on the exposed inner surface of the trench T1 and the exposed surface of the lower connecting part connected to the substrate.

In some embodiments, the deposition process includes a physical vapor deposition (PVD) process, an atomic layer deposition (ALD) process, a pulsed laser deposition (PLD) process, a chemical vapor deposition (CVD) process, vacuum evaporation, and the like.

In some embodiments, the material of the first dielectric layer C3 is selected from at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate, or includes, e.g., at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

After the first dielectric layer C3 is formed, a second electrode layer C4 is formed. A second electrode layer C4 is formed on the first dielectric layer C3 formed on the inner surface of the first electrode, the exposed surface of the support structure connected to the first electrode, the exposed outer surface between the first and second ends of the first electrode, the upper surface of the barrier layer M3, and the inner surface of the trench T2. The first electrode, the second electrode layer overlaying the first electrode, and the first dielectric layer between the first electrode and the second electrode layer jointly form a storage capacitor. The storage capacitors of the stack structure share the second electrode layer.

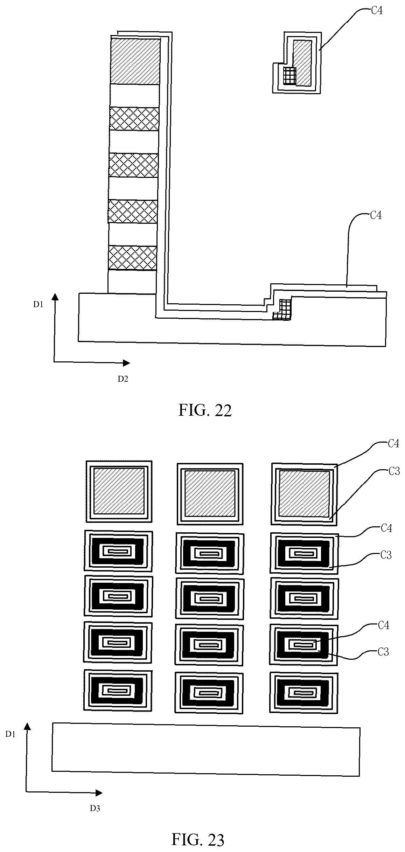

In some embodiments, as shown in FIG. 22, a second electrode layer C4 is formed on the surface of the first dielectric layer C3 formed on the exposed surfaces of the upper connecting part and the barrier layer connected to the upper connecting part, and a second electrode layer C4 is formed on the surface of the first dielectric layer C3 formed on the exposed inner surface of the trench T1 and the exposed surface of the lower connecting part connected to the substrate.

In some embodiments, the process of forming the second electrode layer C4 includes a physical vapor deposition (PVD) process, an atomic layer deposition (ALD) process, a pulsed laser deposition (PLD) process, a chemical vapor deposition (CVD) process, vacuum evaporation, and the like.

In some embodiments, the material of the second electrode layer C4 is selected from metals, metal nitride, metal oxide, metal silicide, conductive carbon, and combinations thereof, such as titanium (Ti), titanium nitride (TiN), titanium aluminum nitride (TiAlN), titanium carbonitride (TiCN), tantalum (Ta), tantalum nitride (TaN), tantalum aluminum nitride (TaAlN), tantalum carbonitride (TaCN), ruthenium (Ru), platinum (Pt), or combinations thereof, or non-metallic materials such as polycrystalline silicon, gallium indium tin oxide, indium tin oxide, or combinations thereof.

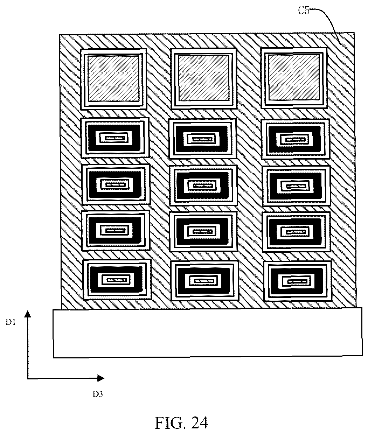

Further, a conductive filling layer C5 is formed on the surface of the second electrode layer C4. As shown in FIG. 24, the gaps of the stack structures and the trenches between the stack structures are filled with the conductive filling layer C5.

In some embodiments, a conductive filling layer C5 is formed in trenches T1 and T2 and covers the upper connecting part and the second electrode layer C4 on the barrier layer connected to the upper connecting part and covers the second electrode layer C4 on the lower connecting part connected to the substrate.

Optionally, the method for forming the second electrode layer C4 may be selected from a physical vapor deposition (PVD) process, an atomic layer deposition (ALD) process, a pulsed laser deposition (PLD) process, a chemical vapor deposition (CVD) process, vacuum evaporation, furnace deposition, and the like.

Optionally, the material of the conductive filling layer C5 is selected from metals, metal nitride, metal oxide, metal silicide, conductive carbon, and combinations thereof, such as titanium (Ti), titanium nitride (TiN), titanium aluminum nitride (TiAlN), titanium carbonitride (TiCN), tantalum (Ta), tantalum nitride (TaN), tantalum aluminum nitride (TaAlN), tantalum carbonitride (TaCN), ruthenium (Ru), platinum (Pt), or combinations thereof, or non-metallic materials such as polycrystalline silicon, gallium indium tin oxide, indium tin oxide, or combinations thereof. Preferably, the conductive filling layer C5 is polycrystalline silicon.

In some embodiments, the memory cell further includes an access transistor including a source, a drain, a gate, and an active layer connected to the source and the drain; the drain is connected to the first end of the first electrode. The gates of the corresponding access transistors in the memory cells of different layers of the stack structure are connected to form a word line extending along the first direction. Optionally, the access transistor may be formed before the first electrode, and specifically, as shown in FIG. 17, the material layer M2 connected to the first electrode may be replaced with the drain of the previously formed access transistor. The corresponding material layer M1 may be replaced with a material layer between the access transistors. Optionally, the access transistor may be formed after the first electrode. As shown in FIG. 17, the material layer M2 connected to the first electrode is etched away, and a drain connected to the first electrode is formed at a corresponding position. Optionally, the access transistor may be manufactured after the capacitor structure is manufactured and before the conductive filling layer C5 is deposited.

In some embodiments, due to the support structure, a relatively long cylindrical first electrode can be designed, and both the exposed inner surface and the exposed outer surface of the first electrode can be used for depositing the first dielectric layer and the second electrode layer, so that the resulting capacitor has a larger effective electrode area and thus the capacitance capacity is larger. In addition, in the manufacturing method for the support structure, an additional patterning process is not needed, and the manufacturing of the support structure can be completed only through a deposition process and an etching process, so that the manufacturing cost is relatively saved, and the mass production is facilitated.

In some embodiments, the access transistor is manufactured before the first electrode. The material layer between the access transistors can support the first end of the first electrode, and meanwhile the support structure at the second end of the first electrode also functions, so that the first electrode can be well prevented from being damaged in the subsequent process and thus the product yield is improved. In addition, in the manufacturing method for the support structure, an additional patterning process is not needed, and the manufacturing of the support structure can be completed only through a deposition process and an etching process, so that the manufacturing cost is relatively saved, and the mass production is facilitated.

In some embodiments, the semiconductor device includes a plurality of stack structures. Each stack structure is provided with a corresponding support structure, and a connecting part is connected between adjacent support structures. The support structures and the connecting parts in the whole semiconductor device form a net shape due to the effect of the connecting parts, which provides a better stabilizing effect and is more beneficial to supporting the first electrodes. The first electrodes can be prevented from being damaged in the subsequent process, and the product yield is improved. In addition, in the manufacturing method for the support structure, an additional patterning process is not needed, and the manufacturing of the support structure can be completed only through a deposition process and an etching process, so that the manufacturing cost is relatively saved, and the mass production is facilitated.

Various semiconductor devices shown in this specific embodiment can be used for an electronic device having a memory function. The electronic device may be a terminal device, e.g., a mobile phone, a tablet computer, a smart bracelet, a personal computer (PC), a server, a workstation, or the like. The memory function in the electronic device can be implemented by using the following memory devices: a dynamic random access memory (DRAM), a ferroelectric random access memory (FRAM), a phase change memory (PCM), a magnetic random access memory (MRAM), or a resistive random access memory (RRAM).

The above description is only the specific embodiments of the present disclosure, but the protection scope of the present disclosure is not limited thereto; changes or substitutions that any one skilled in the art can easily think of within the technical scope disclosed by the present disclosure shall all fall within the protection scope of the present disclosure. Therefore, the protection scope of the present disclosure shall be defined by the protection scope of the claims.

## Claims

1. A semiconductor device (10), comprising:
a substrate (100); and
a stack structure (1000) disposed on the substrate, the stack structure comprising a support structure (400) and memory cells (1100) stacked along a first direction (D1);
wherein, each of the memory cells comprises a cylindrical first electrode (300) extending along a second direction (D2), and the first electrode comprises a first end (310) and a second end (320) along the second direction, wherein the first end is blind, and the second end has an opening and is connected to the support structure, the support structure comprises a first part surrounding a part of an outer surface of the first electrode, the first direction intersects the substrate, and the second direction is parallel to the substrate;
the stack structure further comprises a first dielectric layer (C3) and a second electrode layer (C4), wherein the first dielectric layer covers at least a part of an inner surface of the first electrode, at least a part of an outer surface between the first end and the second end, and at least a part of a surface of the support structure, and
the second electrode layer covers the first dielectric layer.

2. The semiconductor device according to claim 1, wherein the support structure comprises a second part (420) connected to the second end, the second part having an opening, and the opening of the second part at least partially coinciding with the opening of the second end.

3. The semiconductor device according to claim 2, wherein the opening of the second part coincides with the opening of the second end.

4. The semiconductor device according to claim 1, comprising a plurality of stack structures, the plurality of stack structures being arranged along a third direction (D3) parallel to the substrate and intersecting the second direction;
wherein a connecting part (500) is disposed between the support structures of adjacent stack structures.

5. The semiconductor device according to claim 4, wherein the first dielectric layer covers at least a part of a surface of the connecting part.

6. The semiconductor device according to claim 4, wherein the support structure comprises a third end (430) and a fourth end (440) in the first direction, wherein the third end is far away from the substrate, and the fourth end is close to the substrate; the connecting part comprises an upper connecting part (501) and a lower connecting part (502), the upper connecting part connects adjacent third ends, and the lower connect part connects adjacent fourth ends.

7. The semiconductor device according to claim 6, wherein the upper connecting part is farther away from the substrate than the first electrode in the first direction, and the lower connecting part is closer to the substrate than the first electrode in the first direction.

8. The semiconductor device according to claim 1, wherein the first dielectric layer covering at least a part of the outer surface between the first end and the second end surrounds the first electrode with the second direction as an axis.

9. The semiconductor device according to claim 8, wherein the first dielectric layer covering at least a part of the outer surface between the first end and the second end is covered with the second electrode layer.

10. The semiconductor device according to claim 1, further comprising a conductive filling layer (C5) covering the second electrode layer.

11. The semiconductor device according to claim 4, further comprising a conductive filling layer, the conductive filling layer covering the second electrode layer and being partially disposed between adjacent stack structures.

12. A three-dimensional dynamic random access memory (20), comprising:
the semiconductor device according to any one of claims 1-11, a sub-word line driver (SWD), and a sense amplifier (SA).

13. A method for manufacturing a semiconductor device, comprising:
providing a substrate;
forming first electrodes stacked along a first direction on the substrate, wherein each of the first electrodes is in a cylindrical shape extending along a second direction and comprises a first end and a second end along the second direction, and the first end is blind and the second end has an opening;
forming support structures connected to the second ends at the second ends, each of the support structures comprising a first part surrounding a part of an outer surface of the first electrode;
forming a first dielectric layer on at least a part of an inner surface of the first electrode, at least a part of an outer surface between the first end and the second end, and at least a part of a surface of the support structure; and
forming a second electrode layer on the first dielectric layer;
wherein the first direction intersects the substrate, and the second direction is parallel to the substrate.

14. The method for manufacturing a semiconductor device according to claim 13, wherein
forming the first electrodes stacked along the first direction comprises forming a plurality of first electrodes spaced apart and stacked along a third direction parallel to the substrate and intersecting the second direction;
forming the support structures comprises forming a connecting part between the support structures corresponding to adjacent stacks of first electrodes, wherein each of the support structures comprises a third end and a fourth end in the first direction, the third end is far away from the substrate, and the fourth end is close to the substrate; the connecting part comprises an upper connecting part and a lower connecting part, the upper connecting part connects adjacent third ends, and the lower connecting part connects adjacent fourth ends;
forming the first dielectric layer comprises forming the first dielectric layer on at least a part of a surface of the connecting part;
forming the second electrode layer comprises forming the second electrode layer on a surface of the first dielectric layer on at least a part of the surface of the connecting part.

15. The method for manufacturing a semiconductor device according to claim 13, wherein
the support structure is provided with a second part connected to the second end, the second part having an opening, and the opening of the second part being aligned with the opening of the second end.
